# EUROPEAN PATENT APPLICATION

(11) **EP 4 608 094 A2**
(43) Date of publication of application: **27.08.2025**
(21) Application number: 25157419.0
(22) Date of filing: 12.02.2025
(51) Int. Cl.: H10D 89/10, H01L 23/528, H10D 84/01, H10D 84/90

(54) **SEMICONDUCTOR DEVICE INCLUDING SWITCH CELL COUPLED TO BACKSIDE GLOBAL POWER RAIL**

(30) Priority: 21.02.2024 US 202463555956 P; 04.06.2024 US 202418732680
(71) Applicant: Samsung Electronics Co., Ltd., Suwon-si, Gyeonggi-do 16677 (KR)
(72) Inventor: KIM, Jintae, San Jose, CA, 95134 (US); SEO, Kang-Ill, San Jose, CA, 95134 (US)
(74) Representative: Kuhnen & Wacker Patent- und Rechtsanwaltsbüro PartG mbB

(57) **Abstract**

Semiconductor devices are provided. A semiconductor device includes a power-gating cell having a p-type metal-oxide-semiconductor, PMOS, region. The semiconductor device also includes a backside, BS, global power rail. Moreover, the semiconductor device includes a contact that is in contact with both the PMOS region and the BS global power rail.

## Description

### TECHNICAL FIELD

The present disclosure generally relates to the field of semiconductor devices and, more particularly, to semiconductor devices having switch cells.

### BACKGROUND OF THE INVENTION

Integrated circuit (IC) devices, chips, and/or blocks may receive power and data signals from one or more external sources (e.g., a power source and a data source) as part of an operation. Some IC devices may receive power and data signals via front-side (FS) conductive structures. For example, an IC device may include an FS power distribution network (FSPDN) having one or more components that are formed during back end of line (BEOL) processes, and conductive structures for data signals may be on the same side of an IC device as the FSPDN. IC devices may include various transistor structures, including, for example, two-dimensional (2D) planar structures, fin field-effect transistors (FinFETs), gate-all-around transistors, multi-bridge channel FETs (MBCFETs^{™}), and stacked transistors (e.g., three-dimensional (3D) stacked transistors).

More recently, backside PDNs (BSPDNs), in which a backside (BS) of a substrate of an IC device is used as a PDN, have also been developed. For example, a power rail may be used in a BSPDN of an IC device, and may be on a side of the substrate opposite from active components (e.g., transistors) of the IC device. Moreover, conductive structures for data signals may be on an FS of the IC device, and thus the BSPDN and the conductive structures for the data signals may be on opposite sides of the IC device.

An IC device may include multiple cells that may include transistors that are driven using a supply power. External power, however, may not be directly supplied to standard cells of the IC device. Instead, external power may be input to an element referred to as a "power-switch cell" (or "switch cell" or "power-gating cell"), which generates a virtual voltage based on an external power-supply voltage. The virtual voltage output from the switch cell is applied to the standard cells. A sufficient virtual voltage may need to be supplied to the standard cells for stable driving of the IC device. In addition, a ground voltage may need to be supplied to the standard cells.

The IC device may include multiple switch cells, such as metal-oxide-semiconductor (MOS)-based switch cells. The IC device may further include non-power-switch standard cells interposed between the switch cells. A standard cell may be any one of various cells for implementing a logic circuit. For example, the standard cell may provide any one of various logic gates, such as an AND gate, an OR gate, a NOR gate, an XOR gate, and a NOT gate.

### SUMMARY OF THE INVENTION

A semiconductor device, according to some embodiments herein, may include a power-gating cell having a p-type MOS (PMOS) region. The semiconductor device may include a BS global power rail. Moreover, the semiconductor device may include a contact that is in contact with both the PMOS region and the BS global power rail. The power-gating cell may be free of an n-type MOS (NMOS) region.

A semiconductor device, according to some embodiments herein, may include a power-gating cell having a PMOS region. Moreover, the semiconductor device may include a BSPDN having a first power line, a second power line, and a third power line that extend longitudinally in a first direction in parallel with each other. The second power line may be a global power line that is between the first power line and the third power line in a second direction that is perpendicular to the first direction. The semiconductor device may include a first contact that extends longitudinally in the second direction and is in contact with both the PMOS region and the global power line. The PMOS region may be wider, in the second direction, than the first contact. The semiconductor device may include a second contact that is in contact with both the PMOS region and the first power line. Moreover, the semiconductor device may include a third contact that is in contact with the third power line.

A semiconductor device, according to some embodiments herein, may include a switch cell that includes a transistor. The semiconductor device may include a first BS power rail, a second BS power rail, and a third BS power rail that are electrically connected to the transistor. The second BS power rail may be an always-on BS power rail. The semiconductor device may include a first contact that is in contact with both the always-on BS power rail and the transistor. The semiconductor device may include a second contact that is in contact with both the first BS power rail and the transistor. Moreover, the semiconductor device may include a third contact that is in contact with both the third BS power rail and the transistor.

### BRIEF DESCRIPTION OF THE DRAWINGS

FIG. 1A is a schematic block diagram of a device according to some embodiments herein.
FIG. 1B is a schematic block diagram of a switch cell and standard cells of the IC of FIG. 1A.
FIG. 1C is a schematic block diagram of a BSPDN of the IC of FIG. 1A.
FIG. 1D is a schematic block diagram illustrating a contact that is in contact with both a PMOS region of the switch cell of FIG. 1C and a global power rail of the BSPDN of FIG. 1C.
FIGs. 2A, 3A, 4A, and 5A are example block diagrams of the switch cell of FIG. 1C.
FIGs. 2B, 3B, 4B, and 5B are example plan views of the switch cells of FIGs. 2A, 3A, 4A, and 5A, respectively.
FIG. 2C is a cross-sectional view along the line A-A' of FIG. 2B.
FIG. 2D is a cross-sectional view along the line B-B' of FIG. 2B.
FIG. 3C is a cross-sectional view along the line A-A' of FIG. 3B.
FIG. 3D is a cross-sectional view along the line B-B' of FIG. 3B.
FIG. 4C is a cross-sectional view along the line A-A' of FIG. 4B.
FIG. 4D is a cross-sectional view along the line B-B' of FIG. 4B.
FIG. 5C is a cross-sectional view along the line A-A' of FIG. 5B.
FIG. 5D is a cross-sectional view along the line B-B' of FIG. 5B.

### DETAILED DESCRIPTION

A semiconductor device may include a switch cell that can control power consumption of a block or chip. Performance of the switch cell can thus be important. The switch cell can transfer a voltage of a global, always-on power rail to a local power rail that is connected to a normal (i.e., non-power-switch) standard cell. A gate switch may be controlled when a block needs to turn on. Moreover, switching performance may be enhanced based on a design of the switch cell. For example, a wide contacted poly pitch (cpp) (e.g., 20-80 cpp) and/or a multi-height cell (i.e., at least a double-height cell) can enhance switching performance.

Pursuant to embodiments herein, semiconductor (e.g., semiconductor IC) devices are provided that include a switch cell having a PMOS region that is coupled to a global power rail of a BSPDN. The switch cell may be free of an NMOS region (which may not be required for power-gating), and thus may have reduced leakage. In contrast, a conventional switch cell may be a complementary MOS (CMOS) switch cell comprising both a PMOS region and an NMOS region, where the NMOS region may be closer than the PMOS region to a global power rail, thereby making it difficult to connect to the PMOS region to the global power rail and potentially requiring formation of a relatively long contact between the global power rail and the PMOS region. A relatively wide PMOS region according to embodiments herein, however, may occupy a space that would conventionally be occupied by an NMOS region, and thus can be coupled to the global power rail by a relatively short contact (which may be in contact with both the PMOS region and the global power rail). Accordingly, whereas a conventional CMOS switch cell has a PMOS region and an NMOS region that share one logical cell, and whereas a VDD switch cell may have only a conventional (e.g., narrow) PMOS region, a switch cell according to embodiments herein may be free of an NMOS region (which would typically be in a CMOS switch cell) and may include a wide PMOS region that occupies a space that would typically be occupied by the NMOS region.

In some embodiments, the switch cell may have a double cell height and a single PMOS region, which may extend continuously from a first single-height region of the switch cell to a second single-height region of the switch cell. In other embodiments, the switch cell may have a double cell height and two PMOS regions, including a first PMOS region that extends along a majority (i.e., more than 50%) of a height of a first single-height region of the switch cell, and a second PMOS region that extends along a majority of a height of a second single-height region of the switch cell.

Some examples of embodiments of the present disclosure will be described in greater detail with reference to the attached figures.

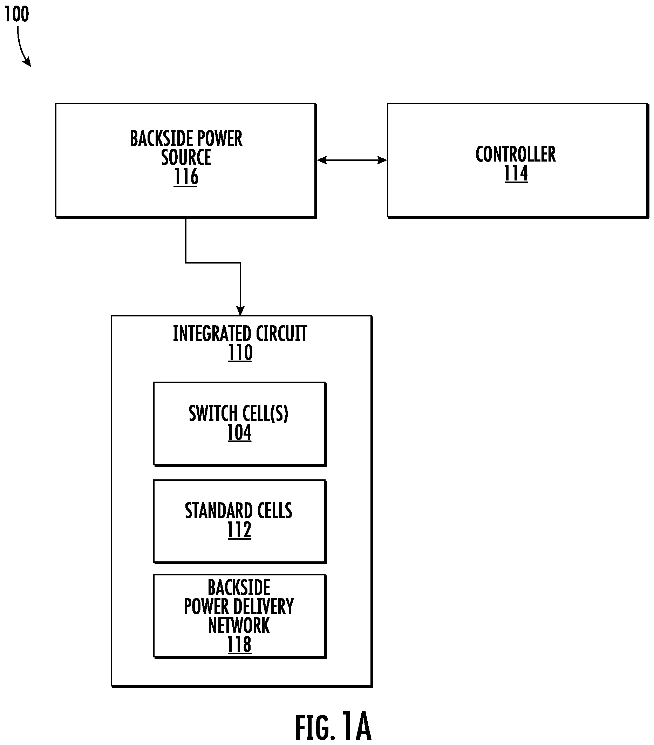

FIG. 1A is a schematic block diagram of a semiconductor device 100 according to some embodiments herein. The device 100 includes an IC 110, which has normal standard cells 112 (e.g., blocks), one or more switch cells 104, and a BSPDN 118. For example, a switch cell 104 may be a PMOS switch cell that includes at least one PMOS transistor and does not include (i.e., is free of) an NMOS transistor.

The device 100 also includes a BS power source 116 that is coupled to the IC 110. The BS power source 116 may provide power signals to the IC 110 at one or more voltage levels. As an example, the BS power source 116 may be configured to provide one or more voltages between 0.4-1.1 volts to the BSPDN 118.

The device 100 further includes a controller 114 that is coupled to the BS power source 116. The controller 114 may include one or more microprocessors that are configured to control operations of the BS power source 116. For example, the controller 114 may include a microprocessor that is configured to turn the BS power source 116 on or off. The controller 114 and the BS power source 116 may be used to perform chip-level power-gating (e.g., turning on or off the entire IC 110) and/or block-level power-gating (e.g., turning on or off individual portions of the IC 110, such as the switch cell(s) 104). As shown in FIG. 1A, the controller 114 may be external to (i.e., outside of) the IC 110 that includes the switch cell(s) 104 and the standard cells 112.

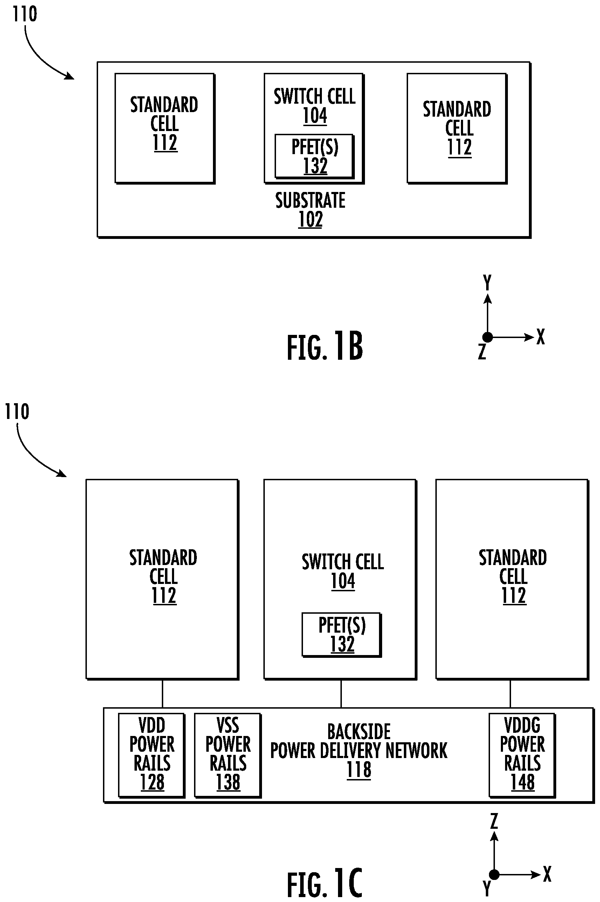

FIG. 1B is a schematic block diagram of a switch cell 104 and standard cells 112 of the IC 110. The switch cell 104 includes one or more transistors in (and/or on) a substrate 102. For example, the switch cell 104 may include at least one PMOS transistor (e.g., a p-type FET (PFET) 132) in (and/or on) the substrate 102. The BSPDN 118 (FIG. 1A) is omitted from view in FIG. 1B, as the BSPDN 118 and the switch cell 104 may be on opposite sides, in a vertical (Z) direction, of the substrate 102. The BSPDN 118 is on a BS of the substrate 102, and the switch cell 104 may be on an FS of the substrate 102.

In some embodiments, the switch cell 104 may be between a pair of the standard cells 112 in a first horizontal (X) direction and/or in a second horizontal (Y) direction. The standard cells 112 may be referred to herein as "normal" standard cells to distinguish them from the switch cells 104. The standard cells 112 thus may not be switch cells, and therefore may not be configured to transfer a voltage of a global power rail to a local power rail.

FIG. 1C is a schematic block diagram of the BSPDN 118 of the IC 110. As shown in FIG. 1C, the BSPDN 118 includes local power rails 128, at least one global power rail 148, and source-supply power rails 138 that are on a BS of the IC 110. Because they are part of the BSPDN 118, the local power rails 128, the global power rail(s) 148, and the source-supply power rails 138 may also be referred to herein as "backside" power rails, each of which may be provided by a respective metal line on the BS of the substrate 102 (FIG. 1B) of the IC 110. For simplicity of illustration, the substrate 102 is omitted from view in FIG. 1C.

A local power rail 128 may provide a virtual voltage (virtual VDD) to a standard cell 112, where the virtual voltage is output to the local power rail 128 by a switch cell 104. The virtual voltage may be generated by the switch cell 104 based on a global, always-on voltage (VDDG) that is supplied to a global power rail 148 by an external power source, such as the BS power source 116 (FIG. 1A). The local power rail 128 may thus also be referred to herein as a "normal" or "virtual" (or "virtual-voltage") power rail, and the global power rail 148 may also be referred to herein as an "always-on" power rail. A source-supply power rail 138 may transmit power, such as a source-supply (e.g., negative or ground power supply) voltage VSS to the switch cell 104. For example, VSS may be zero volts.

In some embodiments, the switch cell 104 may overlap, in the direction Z, the global power rail 148, multiple local power rails 128, and/or multiple source-supply power rails 138. As an example, the switch cell 104 may be a multi-height switch cell that vertically overlaps, and is electrically connected to, the global power rail 148.

Moreover, some of the local power rails 128 may be electrically connected to multiple standard cells 112, in addition to being electrically connected to the switch cell 104. As an example, some of the local power rails 128 may extend longitudinally (i.e., longest) in the direction X and may be electrically connected to two standard cells 112 that are spaced apart from each other in the direction X.

The local power rails 128, the source-supply power rails 138, and the global power rail 148 are examples of conductive (e.g., metal) power lines that are included in the BSPDN 118. These power lines may be arranged in various ways. In some embodiments, the global power rail 148 may be between, in the direction Y, a pair of the local power rails 128. In other embodiments, the global power rail 148 may be between, in the direction Y, a pair of the source-supply power rails 138. Accordingly, the global power rail 148 may be referred to herein as a "second power line" that is between and in parallel with a "first power line" and a "third power line," where the first power line and the third power line may be either a pair of the local power rails 128 or a pair of the source-supply power rails 138.

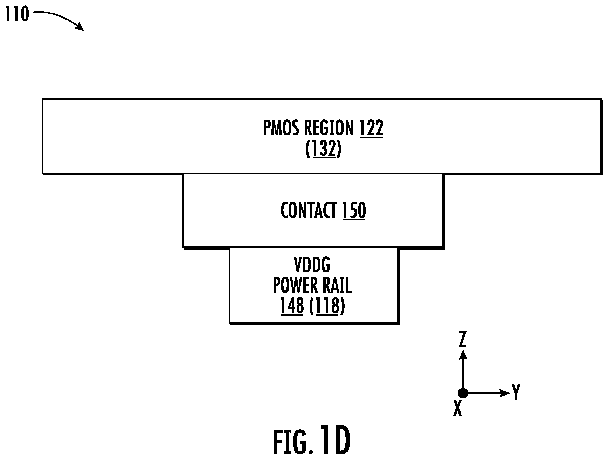

FIG. 1D is a schematic block diagram illustrating a contact 150 that is in contact with both a PMOS region 122 of the switch cell 104 (FIG. 1C) and a global power rail 148 of the BSPDN 118. The PMOS region 122 may be, for example, a source/drain (S/D) region of a PMOS transistor, such as a PFET 132. The contact 150 may be a conductive (e.g., metal) contact having an upper surface that contacts a lower surface of the PMOS region 122 and a lower surface that contacts an upper surface of the global power rail 148. According to some embodiments, the contact 150 may be part of the BSPDN 118.

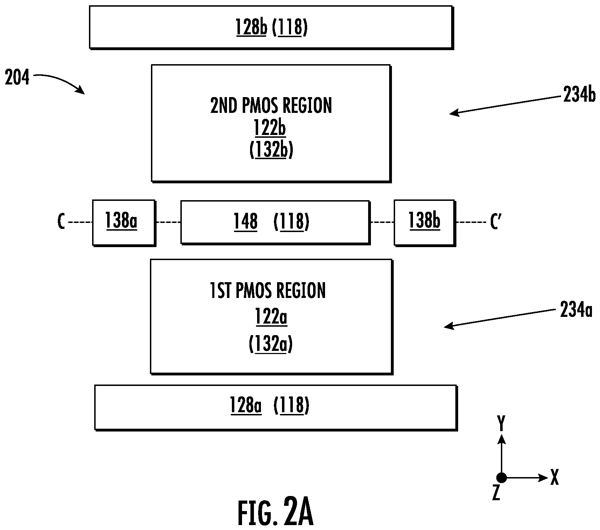

FIGs. 2A, 3A, 4A, and 5A are example block diagrams of the switch cell 104 of FIG. 1C. FIGs. 2A, 3A, 4A, and 5A illustrate a switch cell 204, a switch cell 304, a switch cell 404, and a switch cell 504, respectively. The switch cells 204, 404 each include multiple PMOS regions 122, and the switch cells 304, 504 each include a single PMOS region 122.

As shown in FIG. 2A, the switch cell 204, which is an example of the switch cell 104 of FIG. 1C, includes a first PMOS region 122a and a second PMOS region 122b that are between, in the direction Y, a first local power rail 128a and a second local power rail 128b. In some embodiments, the first PMOS region 122a may be part of (e.g., an S/D region of) a first PFET 132a of the switch cell 204, and the second PMOS region 122b may be part of (e.g., an S/D region of) a second PFET 132b of the switch cell 204. The first local power rail 128a, the second local power rail 128b, and the global power rail 148 may each extend longitudinally in the direction X in parallel with each other.

The switch cell 204 is free of an NMOS region. Accordingly, no NMOS region is present between, in the direction Y, the first local power rail 128a and the second local power rail 128b. Rather, the only MOS regions between the first local power rail 128a and the second local power rail 128b are the first PMOS region 122a and the second PMOS region 122b.

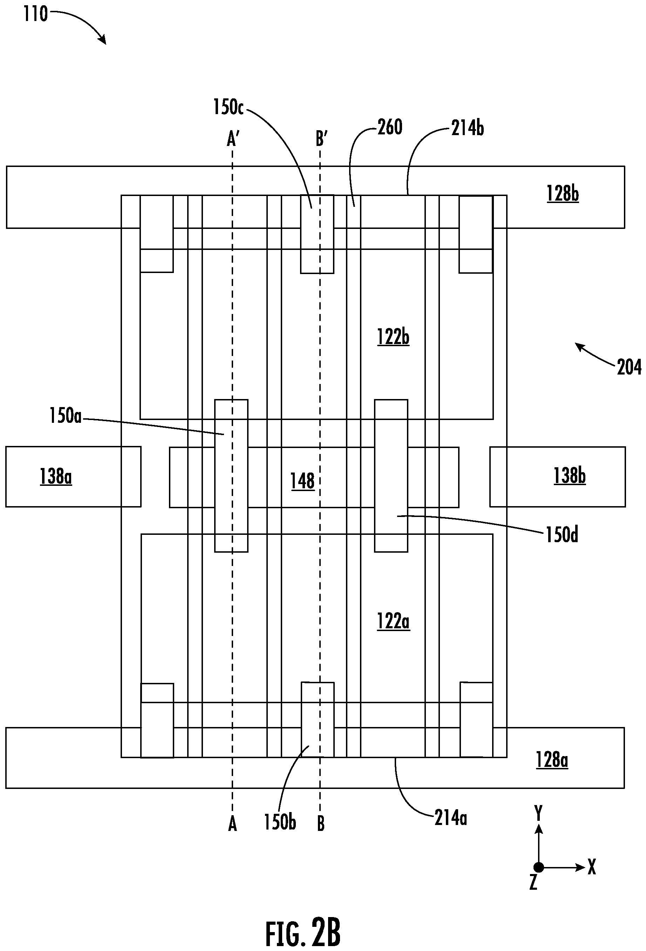

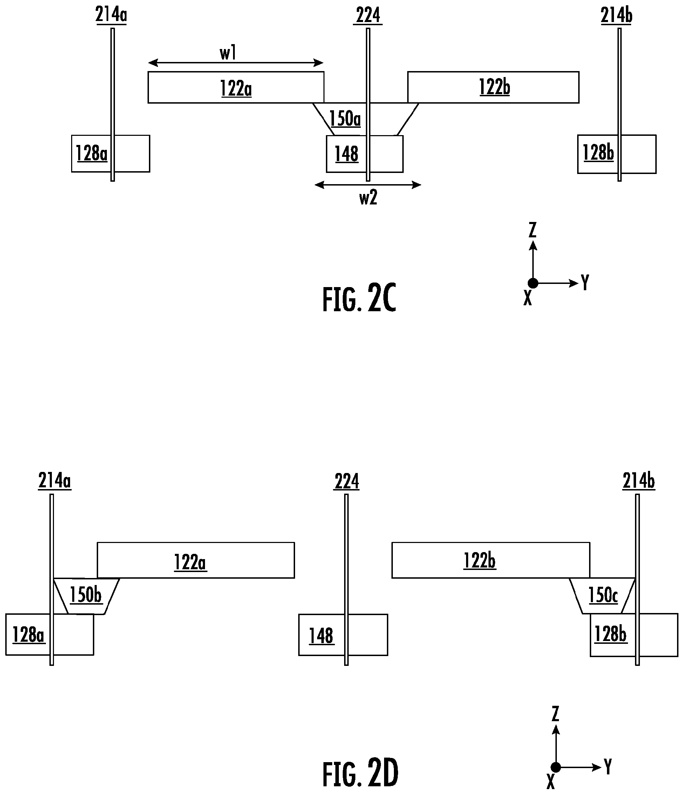

The global power rail 148 may be between (and electrically connected to), in the direction Y, the first PMOS region 122a and the second PMOS region 122b. For simplicity of description, the term "between" may be used herein, with respect to one or more power rails and one or more adj acent PMOS regions 122, to describe the horizontal position(s) of the power rail(s) and the PMOS region(s) 122 as shown in a block diagram (e.g., the block diagram of FIG. 2A) and as shown in further detail in a plan view (e.g., the plan view of FIG. 2B). It will be understood, however, that the BSPDN 118, and thus the power rails therein, is at a different vertical level from that of the PMOS region(s) 122. Accordingly, the term "between," as used herein with respect to one or more power rails and one or more adjacent PMOS regions 122, does not require that an axis extends in the direction Y through the power rail(s) and the adj acent PMOS region(s) 122 in a cross-sectional view (e.g., the cross-sectional views of FIGs. 2C and 2D). Rather, it is sufficient that an axis extends in the direction Y through the power rail(s) and the adjacent PMOS region(s) 122 in a plan view and/or a block diagram.

According to some embodiments, the global power rail 148 may be at a center point, in the direction Y, of the switch cell 204. The center point is a point along a line C-C', which is between, in the direction Y, the first PMOS region 122a and the second PMOS region 122b. The global power rail 148 may thus be centralized in the switch cell 204 and may, in some embodiments, be the only global power rail 148 in the switch cell 204. A first source-supply power rail 138a and a second source-supply power rail 138b can be aligned with the line C-C'. The global power rail 148 can thus be between, the direction X, the first source-supply power rail 138a and the second source-supply power rail 138b.

In some embodiments, the switch cell 204 may be a multi-height cell. For example, the switch cell 204 may have a double cell height. The switch cell 204 may thus have a first single-height region 234a and a second single-height region 234b that are adjacent (e.g., that border) each other in the direction Y. The first PMOS region 122a may be in the first single-height region 234a, and the second PMOS region 122b may be in the second single-height region 234b. As an example, the first PMOS region 122a may extend, in the direction Y, along a majority of a height of the first single-height region 234a, and the second PMOS region 122b may extend, in the direction Y, along a majority of a height of the second single-height region 234b.

The switch cell 204 may transfer a voltage of the global power rail 148 to the first local power rail 128a and/or to the second local power rail 128b. For example, the first PMOS region 122a may be configured to transfer a voltage of the global power rail 148 to the first local power rail 128a, and the second PMOS region 122b may be configured to transfer a voltage of the global power rail 148 to the second local power rail 128b.

FIGs. 2B, 3B, 4B, and 5B are example plan views of the switch cells 204, 304, 404, 504 of FIGs. 2A, 3A, 4A, and 5A, respectively. As shown in FIG. 2B, the switch cell 204 may be coupled to the global power rail 148 by a contact 150a. For example, the contact 150a may be in contact with both the first PMOS region 122a and the global power rail 148. Moreover, the contact 150a may be in contact with both the second PMOS region 122b and the global power rail 148. The same contact 150a may thus be in contact with both of the PMOS regions 122a, 122b and may couple the PMOS regions 122a, 122b to the global power rail 148. In some embodiments, the switch cell 204 may also be coupled to the global power rail 148 by another contact 150d that is spaced apart from the contact 150a in the direction X. The contact 150d, like the contact 150a, may be in contact with the global power rail 148 and with both of the PMOS regions 122a, 122b.

A contact 150b may be in contact with both the first PMOS region 122a and the first local power line 128a. A contact 150c may be in contact with both the second PMOS region 122b and the second local power line 128b. The four contacts 150a-150d, which may be direct backside contacts (DBC), may be referred to herein as "first," "second," "third," and "fourth" contacts, respectively. Moreover, multiple (e.g., two, three, or more) contacts 150 may be in contact with both the first PMOS region 122a and the first local power line 128a, and multiple contacts 150 may be in contact with both the second PMOS region 122b and the second local power line 128b.

The local power rails 128a, 128b are at/adjacent opposite ends of the switch cell 204. For example, a first cell boundary 214a of the switch cell 204 may overlap the first local power rail 128a in the direction Z. Similarly, a second cell boundary 214b of the switch cell 204 may overlap the second local power rail 128b in the direction Z. The first PMOS region 122a may have a first end that is adjacent the first cell boundary 214a, and a second end that is adjacent the global power rail 148. The second PMOS region 122b may have a first end that is adjacent the global power rail 148, and a second end that is adjacent the second cell boundary 214b.

Gate structures 260 may extend continuously in the direction Y such that they overlap the PMOS regions 122a, 122b, the global power rail 148, and the local power rails 128a, 128b in the direction Z. In contrast, each contact 150 may be relatively short. As an example, each contact 150 may be overlapped by no more than an edge portion of each of the PMOS regions 122a, 122b in the direction Z. For example, each contact 150 may be overlapped, in the direction Z, by no more than one-quarter of a width, in the direction Y, of a PMOS region 122. As an example, the contact 150a may be overlapped, in the direction Z, by less than one-quarter of a width, in the direction Y, of the first PMOS region 122a, and less than one-quarter of a width, in the direction Y, of the second PMOS region 122b. In some embodiments, the gate structures 260 may comprise four gate structures that are spaced apart from each other in the direction X.

FIG. 2C is a cross-sectional view along the line A-A' of FIG. 2B. As shown in FIG. 2C, the first PMOS region 122a may have a first width w1, in the direction Y, that is wider than a second width w2, in the direction Y, of the contact 150a. For example, the second width w2 may be less than 75%, or even less than 65%, of the first width w1. The global power rail 148 may have a smaller width, in the direction Y, than the second width w2. The second PMOS region 122b may also have the first width w1. In some embodiments, the switch cell 204 may include only PMOS regions 122 and no NMOS regions. For example, the first PMOS region 122a may be a wide PMOS region that may extend into (and thus occupy) a space in the switch cell 204 that would conventionally be occupied by an NMOS region. Likewise, the second PMOS region 122b may be a wide PMOS region that may occupy a space in the switch cell 204 that would conventionally be occupied by an NMOS region. Moreover, FIG. 2C further shows that an upper surface of the contact 150a may contact both a lower surface of the first PMOS region 122a and a lower surface of the second PMOS region 122b, and a lower surface of the contact 150a may contact an upper surface of the global power rail 148.

A vertical axis 224 extends in the direction Z through a center point, in the direction Y, of the contact 150a (and a center point, in the direction Y, of the global power rail 148). The axis 224 is between (e.g., halfway between) the first cell boundary 214a and the second cell boundary 214b. Though the cell boundaries 214a, 214b are shown in FIG. 2B as extending in the direction X, they may also extend in the direction Z, as shown in FIG. 2C. The cell boundaries 214a, 214b may thus simultaneously extend both vertically and horizontally.

FIG. 2D is a cross-sectional view along the line B-B' of FIG. 2B. As shown in FIG. 2D, an upper surface of the contact 150b may be in contact with a lower surface of the first PMOS region 122a, and a lower surface of the contact 150b may be in contact with an upper surface of the first local power rail 128a. Similarly, an upper surface of the contact 150c may be in contact with a lower surface of the second PMOS region 122b, and a lower surface of the contact 150c may be in contact with an upper surface of the second local power rail 128b.

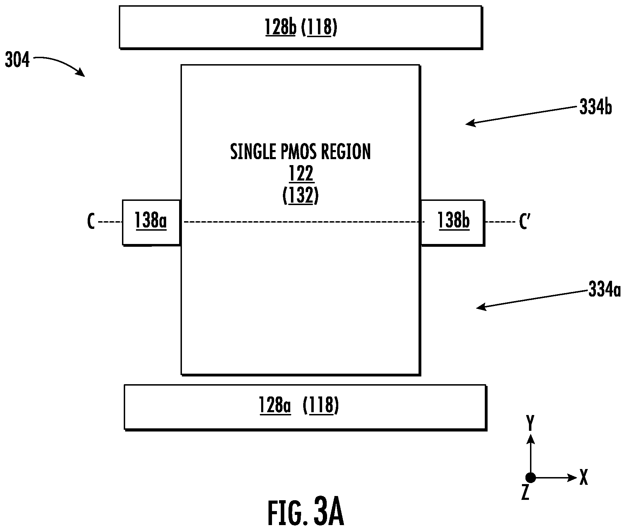

FIG. 3A illustrates a block diagram of the switch cell 304, which is another example of the switch cell 104 of FIG. 1C. The switch cell 304 includes a single PMOS region 122 that is between, in the direction Y, a first local power rail 128a and a second local power rail 128b. The PMOS region 122 may be an S/D region of a transistor 132 (FIG. 1D), which may be the only transistor of the switch cell 304. In some embodiments, the PMOS region 122 may extend, in the direction Y, at least 75% of a distance between the local power rails 128a, 128b. Moreover, the switch cell 304 may include only the PMOS region 122 and no NMOS region. For example, the PMOS region 122 may extend into (and thus occupy) spaces (e.g., one space on each side of the line C-C') in the switch cell 304 that would conventionally be occupied by NMOS regions. The first local power rail 128a, the second local power rail 128b, and the global power rail 148 (FIG. 1D) may each extend longitudinally in the direction X in parallel with each other. The global power rail 148 is omitted from view in FIG. 3A, as it is covered (overlapped) by the PMOS region 122 in the direction Z.

The switch cell 304 is free of an NMOS region. Accordingly, no NMOS region is present between, in the direction Y, the first local power rail 128a and the second local power rail 128b. Rather, the only MOS region between the first local power rail 128a and the second local power rail 128b is the PMOS region 122.

Though not visible in FIG. 3A, it will be understood that the global power rail 148 is electrically connected to the PMOS region 122. According to some embodiments, the global power rail 148 may be at a center point, in the direction Y, of the switch cell 304. The center point is a point along a line C-C', which is between, in the direction Y, opposite ends of the PMOS region 122. A first source-supply power rail 138a and a second source-supply power rail 138b can be aligned with the line C-C'. The global power rail 148 can thus be between, the direction X, the first source-supply power rail 138a and the second source-supply power rail 138b.

In some embodiments, the switch cell 304 may be a multi-height cell. For example, the switch cell 304 may have a double cell height. The switch cell 304 may thus have a first single-height region 334a and a second single-height region 334b that are adjacent (e.g., that border) each other in the direction Y. The PMOS region 122 may be in both the first single-height region 334a and the second single-height region 334b. As an example, the PMOS region 122 may extend, in the direction Y, along a majority of a height of each of the first single-height region 334a and the second single-height region 334b.

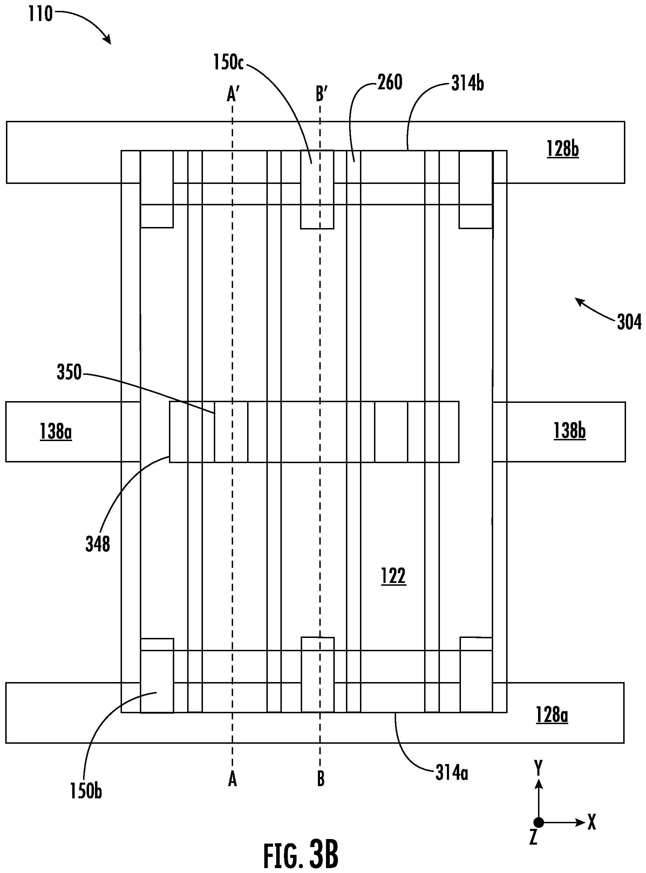

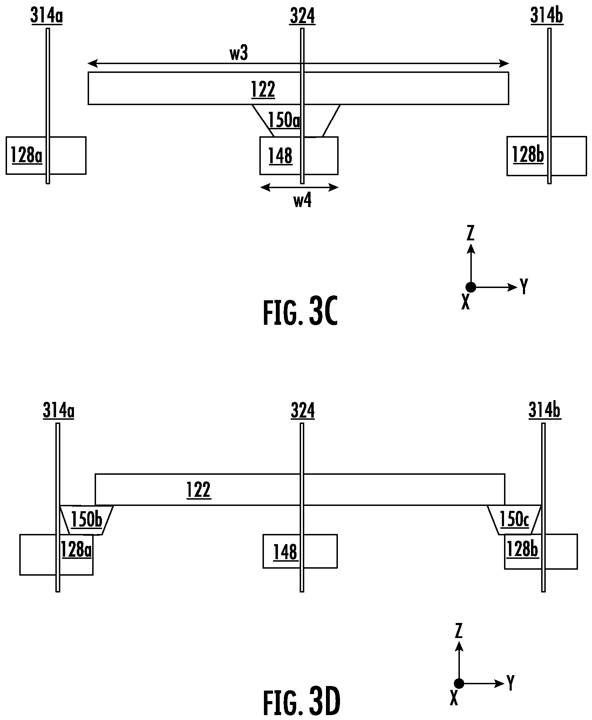

FIG. 3B is an example plan view of the switch cell 304. FIG. 3C is a cross-sectional view along the line A-A' of FIG. 3B. FIG. 3D is a cross-sectional view along the line B-B' of FIG. 3B.

For simplicity of illustration, FIG. 3B shows an outline 348 that represents the global power rail 148 (FIG. 3C) that is overlapped by the PMOS region 122, as well as an outline 350 that represents the contact 150a (FIG. 3C) that is overlapped by the PMOS region 122. Because the PMOS region 122 may overlap an entirety of an upper surface of the global power rail 148 and an entirety of an upper surface of the contact 150a, however, it will be understood that the global power rail 148 and the contact 150a may not be visible in a plan view.

The switch cell 304 may be coupled to the global power rail 148 by the contact 150a. For example, the contact 150a may be in contact with both the PMOS region 122 and the global power rail 148. In some embodiments, the switch cell 304 may also be coupled to the global power rail 148 by another contact 150 (e.g., the contact 150d (FIG. 2B)) that is spaced apart from the contact 150a in the direction X.

A contact 150b may be in contact with both the PMOS region 122 and the first local power line 128a. A contact 150c may be in contact with both the PMOS region 122 and the second local power line 128b. Accordingly, the PMOS region 122 may be in contact with each of the contacts 150a-150c. The PMOS region 122 may thus extend continuously, in the direction Y, from the contact 150b to the contact 150c. Moreover, multiple (e.g., two, three, or more) contacts 150 may be in contact with both the PMOS region 122 and the first local power line 128a, and multiple contacts 150 may be in contact with both the PMOS region 122 and the second local power line 128b.

The local power rails 128a, 128b are at/adjacent opposite ends of the switch cell 304. For example, a first cell boundary 314a of the switch cell 304 may overlap the first local power rail 128a in the direction Z. Similarly, a second cell boundary 314b of the switch cell 304 may overlap the second local power rail 128b in the direction Z. The PMOS region 122 may have a first end that is adjacent the first cell boundary 314a and a second end that is adjacent the second cell boundary 314b. Accordingly, opposite ends of the PMOS region 122 may be adjacent opposite ends, respectively, of the switch cell 304.

As shown in FIG. 3C, the PMOS region 122 may have a third width w3, in the direction Y, that is wider than a fourth width w4, in the direction Y, of the contact 150a. In some embodiments, the global power rail 148 may also have the fourth width w4. The fourth width w4 may be less than half, or even less than one-third, of the third width w3. Because the PMOS region 122 vertically overlaps the entire upper surface of the contact 150a, the fourth width w4 may be narrower than the second width w2 that is shown in FIG. 2C. Also, the PMOS region 122 is the only PMOS region that is in contact with the contact 150a. In some embodiments, the switch cell 304 may include only the PMOS region 122 and no NMOS regions. For example, the PMOS region 122 may be a wide PMOS region that may extend into (and thus occupy) spaces in the switch cell 304 that would conventionally be occupied by NMOS regions. Moreover, FIG. 3C further shows that the entire upper surface of the contact 150a may contact a lower surface of the PMOS region 122, and a lower surface of the contact 150a may contact an upper surface of the global power rail 148.

A vertical axis 324 extends in the direction Z through a center point, in the direction Y, of the contact 150a (and a center point, in the direction Y, of the global power rail 148). The axis 324 is between (e.g., halfway between) the first cell boundary 314a and the second cell boundary 314b. Though the cell boundaries 314a, 314b are shown in FIG. 3B as extending in the direction X, they may also extend in the direction Z, as shown in FIG. 3C. The cell boundaries 314a, 314b may thus simultaneously extend both vertically and horizontally.

The switch cell 304 may transfer a voltage of the global power rail 148 to the first local power rail 128a and/or to the second local power rail 128b. For example, the PMOS region 122 may be configured to transfer a voltage of the global power rail 148 to the first local power rail 128a and/or the second local power rail 128b.

As shown in FIG. 3D, an upper surface of the contact 150b may be in contact with a lower surface of the PMOS region 122, and a lower surface of the contact 150b may be in contact with an upper surface of the first local power rail 128a. Similarly, an upper surface of the contact 150c may be in contact with a lower surface of the PMOS region 122, and a lower surface of the contact 150c may be in contact with an upper surface of the second local power rail 128b.

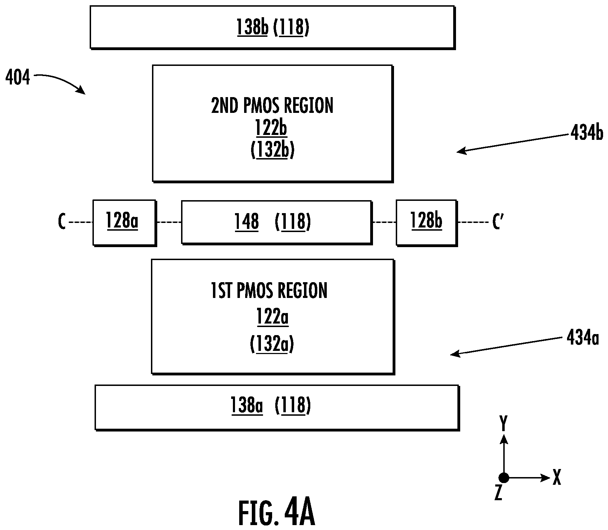

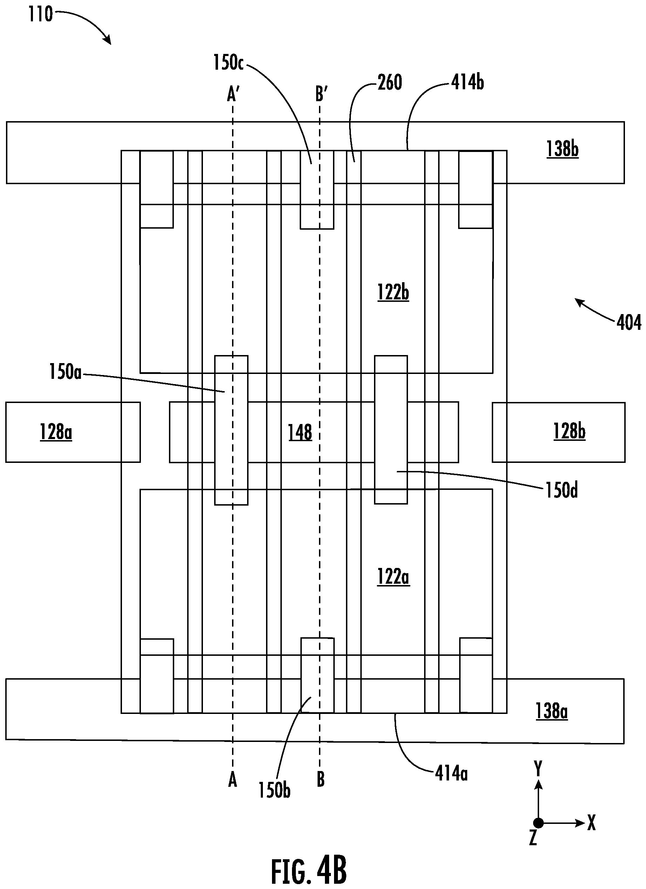

FIGs. 4A and 4B illustrate a block diagram and a plan view, respectively, of the switch cell 404, which is a further example of the switch cell 104 of FIG. 1C. The switch cell 404 is analogous to the switch cell 204 shown in FIGs. 2A and 2B, except that the source-supply power rails 138a, 138b swap places with the local power rails 128a, 128b. Accordingly, the first PMOS region 122a and the second PMOS region 122b of the switch cell 404 are between, in the direction Y, the first source-supply power rail 138a and the second source-supply power rail 138b. The global power rail 148 extends longitudinally in the direction X in parallel with the source-supply power rails 138a, 138b. Moreover, the global power rail 148 is between, in the direction X, the first local power rail 128a and the second local power rail 128b. A first single-height region 434a of the switch cell 404 is analogous to the first single-height region 234a of the switch cell 204 (in that the first PMOS region 122a is therein), and a second single-height region 434b of the switch cell 404 is analogous to the second single-height region 234b of the switch cell 204 (in that the second PMOS region 122b is therein).

The switch cell 404 is free of an NMOS region. Accordingly, no NMOS region is present between, in the direction Y, the first source-supply power rail 138a and the second source-supply power rail 138b. Rather, the only MOS regions between the first source-supply power rail 138a and the second source-supply power rail 138b are the first PMOS region 122a and the second PMOS region 122b.

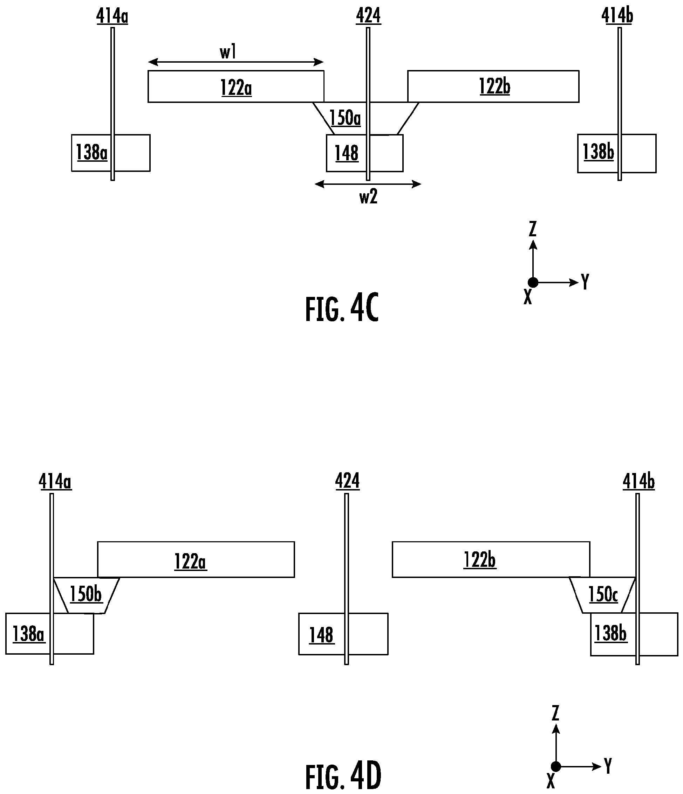

FIGs. 4C and 4D are analogous to FIGs. 2C and 2D, respectively, except that the source-supply power rails 138a, 138b swap places with the local power rails 128a, 128b. Accordingly, a first cell boundary 414a may overlap, in the direction Z, the first source-supply power rail 138a, and a second cell boundary 414b may overlap, in the direction Z, the second source-supply power rail 138b. Moreover, an upper surface of the contact 150b may contact a lower surface of the first PMOS region 122a, and a lower surface of the contact 150b may contact an upper surface of the first source-supply region 138a. Similarly, an upper surface of the contact 150c may contact a lower surface of the second PMOS region 122b, and a lower surface of the contact 150c may contact an upper surface of the second source-supply region 138b. A vertical axis 424 is analogous to the vertical axis 224 in FIGs. 2C and 2D.

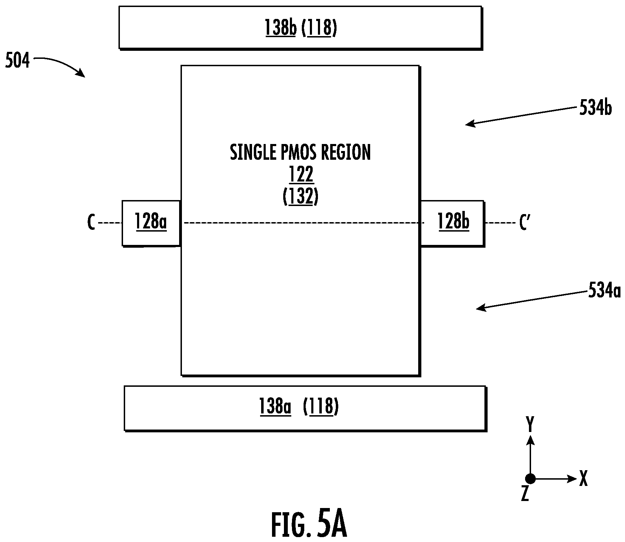

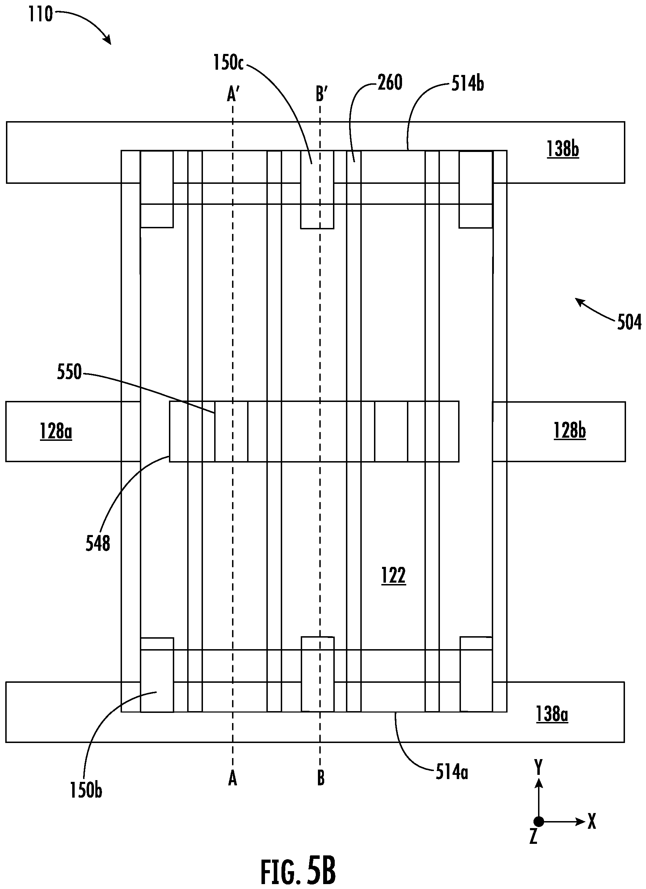

FIGs. 5A and 5B illustrate a block diagram and a plan view, respectively, of the switch cell 504, which is another example of the switch cell 104 of FIG. 1C. The switch cell 504 is analogous to the switch cell 304 shown in FIGs. 3A and 3B, except that the source-supply power rails 138a, 138b swap places with the local power rails 128a, 128b. Accordingly, the PMOS region 122 of the switch cell 504 is between, in the direction Y, the first source-supply power rail 138a and the second source-supply power rail 138b. Moreover, the global power rail 148 is between, in the direction X, the first local power rail 128a and the second local power rail 128b. A first single-height region 534a of the switch cell 504 is analogous to the first single-height region 334a of the switch cell 304, and a second single-height region 534b of the switch cell 504 is analogous to the second single-height region 334b of the switch cell 304. The PMOS region 122 is thus in both of the regions 534a, 534b. Also, FIG. 5B shows outlines 548, 550 that are analogous to the outlines 348, 350 shown in FIG. 3B.

The switch cell 504 is free of an NMOS region. Accordingly, no NMOS region is present between, in the direction Y, the first source-supply power rail 138a and the second source-supply power rail 138b. Rather, the only MOS region between the first source-supply power rail 138a and the second source-supply power rail 138b is the PMOS region 122.

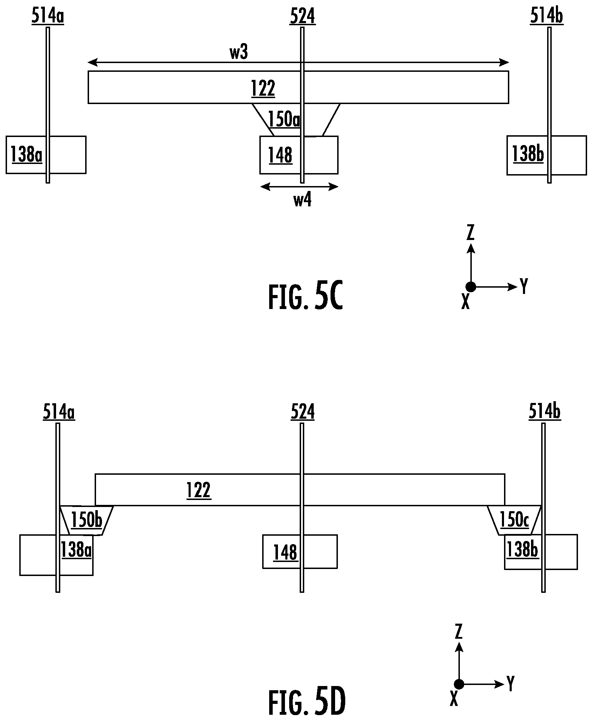

FIGs. 5C and 5D are analogous to FIGs. 3C and 3D, respectively, except that the source-supply power rails 138a, 138b swap places with the local power rails 128a, 128b. Accordingly, a first cell boundary 514a may overlap, in the direction Z, the first source-supply power rail 138a, and a second cell boundary 514b may overlap, in the direction Z, the second source-supply power rail 138b. Moreover, an upper surface of the contact 150b may contact a lower surface of the PMOS region 122, and a lower surface of the contact 150b may contact an upper surface of the first source-supply region 138a. Similarly, an upper surface of the contact 150c may contact the lower surface of the PMOS region 122, and a lower surface of the contact 150c may contact an upper surface of the second source-supply region 138b. A vertical axis 524 is analogous to the vertical axis 324 in FIGs. 3C and 3D.

Devices 100 (FIG. 1A) according to some embodiments herein may provide various advantages. These advantages may include electrically connecting a PMOS region 122 (FIG. 1D) of a switch cell 104 (FIG. 1C) to a global power rail 148 (FIG. 1D) of a BSPDN 118 (FIG. 1C) by a contact 150 (FIG. 1D) that is relatively short in length, which can be beneficial when forming the contact 150 and can improve performance of a power-gating cell (e.g., the switch cell 104). The use of the short contact 150 may be facilitated by the PMOS region 122 having a relatively wide width such that the PMOS region 122 extends adjacent the contact 150. For example, the PMOS region 122 may occupy a space that would conventionally be occupied by an NMOS region. Moreover, the length of the contact 150 may be further shortened by using a PMOS region 122 that vertically overlaps an entire upper surface of the contact 150, as shown in FIGs. 3C and 5C. The advantages may also include reducing leakage by using a switch cell 104 that includes one or more PMOS regions 122 and does not include any NMOS regions. As a result, the switch cell 104 may provide efficient power-gating.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of appended claims.

## Claims

1. A semiconductor device comprising:
a power-gating cell comprising a p-type metal-oxide-semiconductor, PMOS, region;
a backside, BS, global power rail; and
a first contact that is in contact with both the PMOS region and the BS global power rail,
wherein the power-gating cell is free of an n-type metal-oxide-semiconductor, NMOS, region.

2. The semiconductor device of Claim 1,
wherein the BS global power rail extends longitudinally in a first direction,
wherein the first contact extends longitudinally in a second direction that is perpendicular to the first direction, and
wherein the PMOS region is wider, in the second direction, than the first contact.

3. The semiconductor device of Claim 2, further comprising a first BS local power rail and a second BS local power rail that extend longitudinally in the first direction in parallel with the BS global power rail,
wherein the BS global power rail is between, in the second direction, the first BS local power rail and the second BS local power rail.

4. The semiconductor device of Claim 3, further comprising a second contact that is in contact with both the PMOS region and the first BS local power rail.

5. The semiconductor device of Claim 4, further comprising a third contact that is in contact with both the PMOS region and the second BS local power rail,
wherein the BS global power rail is less than half as wide, in the second direction, as the PMOS region.

6. The semiconductor device of Claim 4 or 5,
wherein the power-gating cell further comprises a second PMOS region that is in contact with the first contact,
wherein the BS global power rail is less than 75% as wide, in the second direction, as the second PMOS region, and
wherein the semiconductor device further comprises a third contact that is in contact with both the second PMOS region and the second BS local power rail.

7. The semiconductor device of Claim 2, further comprising a first BS source-supply power rail and a second BS source-supply power rail that extend longitudinally in the first direction in parallel with the BS global power rail,
wherein the BS global power rail is between, in the second direction, the first BS source-supply power rail and the second BS source-supply power rail.

8. The semiconductor device of Claim 7, further comprising a second contact that is in contact with both the PMOS region and the first BS source-supply power rail.

9. The semiconductor device of Claim 8, further comprising a third contact that is in contact with both the PMOS region and the second BS source-supply power rail,
wherein the BS global power rail is less than half as wide, in the second direction, as the PMOS region.

10. The semiconductor device of Claim 8 or 9,
wherein the power-gating cell further comprises a second PMOS region that is in contact with the first contact,
wherein the BS global power rail is less than 75% as wide, in the second direction, as the second PMOS region, and
wherein the semiconductor device further comprises a third contact that is in contact with both the second PMOS region and the second BS source-supply power rail.

11. The semiconductor device according to claim 1, comprising:
a backside power delivery network, BSPDN, comprising a first power line, a second power line, and a third power line that extend longitudinally in the first direction in parallel with each other, wherein the second power line comprises the BS global power rail that is between the first power line and the third power line in a second direction that is perpendicular to the first direction, and wherein the PMOS region is wider, in the second direction, than the first contact;
a second contact that is in contact with both the PMOS region and the first power line; and
a third contact that is in contact with the third power line.

12. The semiconductor device of Claim 11, wherein the PMOS region extends continuously in the second direction from the second contact to the third contact.

13. The semiconductor device of Claim 11 or 12, further comprising a second PMOS region that is in contact with the first contact and the third contact.

14. The semiconductor device of any one of Claims 11 to 13, further comprising a fourth contact that is in contact with both the PMOS region and the BS global power rail,
wherein a center point, in the second direction, of the power-gating cell overlaps the BS global power rail in a third direction that is perpendicular to the first direction and the second direction.

15. The semiconductor device of any one of Claims 11 to 14,
wherein the first power line and the third power line comprise respective local power lines of the BSPDN, and
wherein the first contact, the second contact, and the third contact are part of the BSPDN.
